# EUROPÄISCHE PATENTSCHRIFT

(11) **EP 1 236 227 B1**
(45) Veröffentlichungstag und Bekanntmachung des Hinweises auf die Patenterteilung: **02.08.2006**
(21) Anmeldenummer: 00983242.9
(22) Anmeldetag: 07.12.2000
(51) Int. Cl.: H01L 21/56, G01N 21/00

(54) **VERFAHREN UND HERSTELLUNG EINES SENSORS**
METHOD AND PRODUCTION OF A SENSOR
PROCEDE DE PRODUCTION D'UN DETECTEUR

(30) Priorität: 09.12.1999 DE 19959345
(43) Veröffentlichungstag der Anmeldung: 04.09.2002
(73) Patentinhaber: Micronas GmbH, 79108 Freiburg i. Br. (DE)
(72) Erfinder: IGEL, Günter, 79331 Teningen (DE); ROGALLA, Markus, 79189 Bad Krozingen (DE)
(74) Vertreter: Bickel, Michael
(86) Internationale Anmeldenummer: PCT/EP2000/012338
(87) Internationale Veröffentlichungsnummer: WO 2001/042766

(56) Entgegenhaltungen:
- EP-A- 0 398 587
- PATENT ABSTRACTS OF JAPAN vol. 007, no. 099 (E-172), 27. April 1983 (1983-04-27) & JP 58 021358 A (SEIKOO KEIYOU KOGYO KK), 8. Februar 1983 (1983-02-08)

## Beschreibung

Die Erfindung betrifft ein Verfahren zum Herstellen eines Sensors, wobei ein eine Sensorstruktur mit einer aktiven Sensorfläche aufweisender Trägerchip bereitgestellt und auf den die aktive Sensorfläche umgrenzenden Oberflächenbereich des Trägerchips ein fließfähiges Material als Umgrenzung aufgebracht und dieses Material anschließend verfestigt wird.

Aus der Praxis kennt man bereits ein Verfahren der eingangs genannten Art, bei dem vor dem Aufbringen des fließfähigen Materials auf den Sensorchip zunächst auf die aktive Sensorfläche ein Stempel aufgesetzt wird, der die Sensorfläche abdeckt. Der Stempel ist dazu mit seiner Außenkontur an die Außenkontur der Sensorfläche angepaßt, so daß er in Gebrauchsstellung nur die Sensorfläche abdeckt, während die Umgrenzungsbereiche der Sensorfläche freigehalten werden. Der in Gebrauchsstellung an der aktiven Sensorfläche anliegende Oberflächenbereich des Stempels ist in seiner Oberflächenstruktur an diejenige der aktiven Sensorfläche formangepaßt, so daß der auf die Sensorfläche aufgesetzte Stempel diese gegen das fließfähige Material abdichtet. Dieses wird dann im Umgrenzungsbereich des Stempels auf die Oberfläche des Sensorchips aufgebracht und danach verfestigt. Das fließfähige Material kann beispielsweise eine Kunststoffmasse sein, die nach dem Auftragen auf dem Sensorchip aushärtet oder erstarrt. Die aktive Sensorfläche ist dann für den Kontakt mit einem zu untersuchenden Medium frei zugänglich, während die die aktive Sensorfläche seitlich umgrenzenden Oberflächenbereiche durch die Kunststoffmasse abgedichtet sind.

Der Oberbegriff des Anspruchs 1 ist aus dem Dokument EP-A-0 398 587 bekannt.

Das Verfahren hat jedoch den Nachteil, daß der Stempel sehr genau an der Sensorfläche positioniert werden muß, damit ein Eindringen des fließfähigen Materials zwischen Stempel und Sensorfläche und somit eine Bedeckung der Sensorfläche mit dem fließfähigen Material vermieden wird. Ungünstig ist vor allem, daß der Trägerchip beim Aufsetzen des Stempels auf die Sensorfläche beschädigt und somit in seiner Funktion unbrauchbar oder zumindest beeinträchtigt wird. Ein weiterer Nachteil des Verfahrens besteht darin, daß die Herstellung des Stempels und insbesondere dessen zu der Oberflächenstruktur der Sensorfläche komplementären Oberflächenstruktur des in Gebrauchsstellung an der Sensorfläche anliegenden Teilbereich des Stempels noch vergleichsweise aufwendig ist. Schließlich ist das vorbekannte Verfahren aber auch für eine Automatisierung und somit eine kostengünstige Herstellung von Sensoren in Großserie praktisch nicht geeignet.

Es besteht deshalb die Aufgabe, ein Verfahren der eingangs genannten Art zu schaffen, das auf einfache Weise das Aufbringen einer an die aktive Sensorfläche angrenzenden Umgrenzung auf die Sensorstruktur ermöglicht. Dabei soll eine Beschädigung der Sensorstruktur sicher vermieden werden.

Die Lösung dieser Aufgabe besteht darin, daß das fließfähige Material auf der aktiven Sensorfläche der Sensorstruktur mit einer geringeren Schichtdicke aufgetragen wird als in dem die aktive Sensorfläche umgrenzenden Bereich des Trägerchips, und daß das fließfähige Material nach seinem Verfestigen an seiner dem Trägerchip abgewandten Oberfläche ganzflächig chemisch abgetragen wird, bis die aktive Sensorfläche der Sensorstruktur freigelegt ist.

In scheinbar widersprüchlicher Weise wird also das fließfähige Materal außer auf den die Sensorfläche umgrenzenden Bereich des Trägerchips auch auf die Sensorfläche selbst aufgetragen, obwohl diese eigentlich von dem fließfähigen Material freigehalten werden soll. Das fließfähige Material wird dabei im Bereich der aktiven Sensorfläche mit einer geringeren Dicke aufgetragen als in den seitlich daran angrenzenden Bereichen. Nach dem Verfestigen des Materials wird sowohl im Bereich der aktiven Sensorfläche als auch in den seitlich daran angrenzenden Bereichen des fließfähigen Material an seiner dem Trägerchip abgewandten Oberfläche mit einem Medium in Kontakt gebracht, das mit dem verfestigten Material eine chemische Bindung eingeht, wobei das verfestigte Material abgetragen wird. Der chemische Abtragungsprozeß wird gestoppt, wenn das verfestigte Material im Bereich der aktiven Sensorfläche vollständig abgetragen und somit die darunter befindliche Sensorfläche freigelegt ist. Da das fließfähige Material in den seitlich an die Sensorfläche angrenzenden Bereichen mit einer größeren Schichtdicke aufgetragen wurde als im Bereich der Sensorfläche, sind die seitlich zu der Sensorfläche benachbarten Bereiche nach dem Freilegen der Sensorfläche weiterhin von dem verfestigten Material bedeckt. Das zum Abtragen des verfestigten Materials verwendete chemische Medium wird so gewählt, daß es das Material, aus dem zumindest der die Sensorfläche aufweisende Teilbereich der Sensorstruktur besteht, chemisch nicht angreift. Das erfindungsgemäße Verfahren ermöglicht also auf einfache Weise das Aufbringen einer an die Sensorfläche seitlich angrenzenden Umgrenzung auf die Sensorstruktur, wobei die Sensorfläche von dem Material der Umgrenzung freibleibt. Eine Beschädigung der Sensorstruktur wird sicher vermieden. Das Verfestigen des fließfähigen Materials kann in an sich bekannter Weise durch Aushärten, Erstarren und/oder Verdampfen eines in dem fließfähigen Materials enthaltenen Lösungsmittels erfolgen.

Vorteilhaft ist, wenn das fließfähige Material nach dem Verfestigen durch Ätzen abgetragen wird, insbesondere durch Plasmaätzen. Das Verfahren kann dann besonders gut in einen Halbleiterfertigungsprozeß integriert werden. Dabei können der Trägerchip und/oder die darauf befindliche Sensorstruktur gegebenenfalls aus einem Halbleitermaterial bestehen.

Besonders vorteilhaft ist, wenn das fließfähige Material in einem Spritzgießwerkzeug auf den Trägerchip aufgespritzt wird und wenn das Spritzgießwerkzeug einen stempelartigen Vorsprung aufweist, der in Gebrauchstellung der aktiven Sensorfläche zugewandt ist und diese überdeckt und mit seinem Umgrenzungsrand mit demjenigen der aktiven Sensorfläche fluchtet. Der die Sensorstruktur aufweisende Trägerchip kann dan auf einfache Weise mit einem als Spritzpreßmittel ausgebildeten fließfähigen Material umspritzt werden. Dabei kann gegebenenfalls ein zur Umhüllung herkömmlicher elektronischer Bauelemente verwendetes Spritzpreßmittel zur Anwendung kommen, beispielsweise ein thermoplastischer Kunststoff. Das Verfahren eignet sich besonders zur industriellen Serienfertigung großer Stückzahlen von Sensoren.

Bei einer vorteilhaften Ausführungsform der Erfindung wird zumindest auf die freigelegte Sensorfläche der Sensorstruktur ein die Sensorfläche überdeckendes, fließfähiges Zusatzmaterial aufgetragen und danach verfestigt. Dabei gerät das Zusatzmaterial nur mit der aktiven Sensorfläche in Berührung, während die übrigen Bereiche der Sensorstruktur durch das die Umgrenzung der Sensorfläche bildende verfestigte Material von dem Zusatzmaterial beabstandet sind. Dadurch ist es sogar möglich, ein Zusatzmaterial auf die Sensorstruktur aufzubringen, das nur mit der aktiven Sensorfläche, nicht jedoch mit den übrigen Bereichen der Sensorstruktur in Berührung geraten darf. Das Zusatzmaterial kann insbesondere ein für die Funktion des Sensors erforderliches Material sein, beispielsweise eine ionendurchlässige Membran für einen ionenselektiven Sensor, eine lichtdurchlässige Schicht für einen optischen Sensor, ein optischer Filter, eine optische Linse oder ein anderes, sich von dem die Umgrenzung bildenden, verfestigten Material unterscheidendes Material sein.

Besonders vorteilhaft ist, wenn das fließfähige Zusatzmaterial in dem Spritzgießwerkzeug auf den Sensor aufgespritzt wird. Das Zusatzmaterial füllt dann die chemisch abgetragenen Bereiche des für die Umgrenzung der Sensorfläche auf die Sensorstruktur beziehungsweise den Trägerchip aufgebrachten verfestigten Materials aus. In vorteilhafter Weise kann somit für das Aufspritzen des Zusatzmaterials dasselbe Spritzgießwerkzeug verwendet werden, wie für das Aufspritzen des die Umgrenzung der Sensorfläche bildenden Materials. Somit kann ein teures zusätzliches Spritzgießwerkzeug eingespart werden.

Bei einer Ausführungsform der Erfindung ist vorgesehen, daß der Trägerchip beim Aufbringen des fließfähigen Materials und gegebenenfalls des Zusatzmaterials auf einem Frame angeordnet ist, daß in der Innenhöhlung des Spritzgießwerkzeug Öffnungen für die Aufnahme und/oder den Durchtritt von Teilbereichen des Frames vorgesehen sind, und daß die Umgrenzungsränder der Öffnungen in Gebrauchsstellung dichtend an diesen Teilbereichen anliegen. Diese Teilbereiche des Frames bleiben dann frei von dem fließfähigen Material und gegebenenfalls dem Zusatzmaterial und können beispielsweise mit externen elektrischen Anschlußkontakten zum Verbinden des Sensors mit einer elektrischen oder elektronischen Schaltung versehen sein. Die Anschlußkontakte können über einerseits an dem Frames und andererseits an dem Trägerchip und/oder der Sensorstruktur angreifenden Bond-Drähten mit der Sensorstruktur verbunden sein.

Bei einer anderen vorteilhaften Ausführungsform der Erfindung ist vorgesehen, daß als fließfähiges Material ein photoempfindliches Material auf die aktive Sensorfläche und den diese umgrenzenden Oberflächenbereich des Trägerchips aufgebracht wird, daß das Material danach mittels eines Maskierungs- und Entwicklungsprozesses derart bereichsweise abgetragen wird, daß das verbleibende Material auf der aktiven Sensorfläche der Sensorstruktur eine geringere Schichtdicke aufweist als in dem die aktive Sensorfläche umgrenzenden Bereich des Trägerchips, und daß das Material danach ganzflächig chemisch abgetragen wird, bis die aktive Sensorfläche der Sensorstruktur freigelegt ist. Nach dem Auftragen des fließfähigen, photoempfindlichen Materials auf den Trägerchip wird dieses gegebenenfalls konditioniert, beispielsweise unter Wärmeeinwirkung. Bei dem anschließenden Maskierungsprozeß wird das photoempfindliche Material in an sich bekannter Weise bereichsweise belichtet, beispielsweise indem optische Strahlung durch eine Fotomaske hindurch auf das photoempfindliche Material projiziert wird. Bei Verwendung eines photopositiven Materials wird das auf der aktiven Sensorfläche befindliche photoempfindliche Material belichtet, während das übrige photoempfindliche Material unbelichtet bleibt. In entsprechender Weise wird bei Verwendung eines photonegativen Materials das auf dem die aktive Sensorfläche umgrenzenden Oberflächenbereich des Trägerchips befindliche photoempfindliche Material belichtet, während das auf der aktiven Sensorfläche befindliche photoempfindliche Material unbelichtet bleibt. In dem anschließenden Entwicklungsprozeß wird dann das auf der aktiven Sensorfläche befindliche Material beim Kontakt mit dem Entwickler stärker abgetragen als das gegen den Entwickler im wesentlichen beständige übrige Material. Der Belichtungs- und Entwicklungsprozeß kann so geführt werden, daß das auf der aktiven Sensorfläche befindliche Material nach dem Entwickeln nur noch eine sehr geringe Schichtdicke aufweist. Dadurch wird die Gefahr, daß bei dem anschließenden ganzflächigen chemischen Abtragen des verbleibenden Materials sich in den an den Rand der aktiven Sensorfläche angrenzenden Materialbereichen Hinterschneidungen oder Unterätzungen ausbilden, praktisch vermieden. Dies ist insbesondere dann von Vorteil, wenn das verbleibende Material durch isotropes Ätzen abgetragen wird.

Nachfolgend ist ein Ausführungsbeispiel der Erfindung anhand der Zeichnung näher erläutert. Es zeigen zum Teil stärker schematisiert:
- Fig. 1: einen Teilquerschnitt durch ein Spritzgießwerkzeug, in welchem ein auf einem Frame angeordneter, eine aktive Sensorfläche aufweisender Halbleiterchip mit einem fließfähigen Material umspritzt wird,
- Fig. 2: einen Teilquerschnitt durch den aus dem Spritzgießwerkzeug entnommenen Halbleiterchip beim Abtragen des aufgespritzten und verfestigten Materials,
- Fig. 3: einen Teilquerschnitt durch die in Fig.2 gezeigte Anordnung nach dem Freilegen der aktiven Sensorfläche des Halbleiterchips und
- Fig. 4: einen Teilquerschnitt durch den in Fig.3 gezeigten Sensor nach dem Umspritzen mit einem Zusatzmaterial.

Bei einem Verfahren zum Herstellen eines im ganzen mit 1 bezeichneten Sensor wird ein als Halbleiterchip ausgebildeter Trägerchip 2 bereitgestellt, der eine Sensorstruktur 3 mit einer aktiven Sensorfläche 4 aufweist. Der Trägerchip 2 ist in aus der Halbleiterfertigungstechnik an sich bekannter Weise zusammen mit weiteren Trägerchips auf einem Frame 5 angeordnet und haftet über eine zwischen dem Trägerchip 2 und dem Frame 5 befindliche Klebeschicht 6 an dem Frame 5 an. Der auf dem Frame 5 angeordnete Trägerchip 2 wird in die Innenhöhlung eines Spritzgießwerkzeuges eingesetzt, das zwei relativ zueinander bewegbare, in eine Offen- und eine Schließstellung bringbare Formteile 7a, 7b hat. Danach wird das Spritzgießwerkzeug geschlossen.

Das Spritzgießwerkzeug weist in der Zeichnung nicht dargestellte Öffnungen auf, die in der Trennebene der Formteile 7a, 7b angeordnet sind und in Schließstellung der Formteile 7a, 7b Teilbereiche des in die Innenhöhlung des Spritzgießwerkzeugs eingesetzten Frames 5 aufnehmen. Die Form der Öffnungen ist so an die Form der darin eingesetzten Teilbereiche des Frames 5 angepaßt, daß die Umgrenzungsränder der Öffnungen in Schließstellung der Formteile 7a, 7b jeweils dichtend an den in die Öffnungen eingesetzten Teilbereichen des Frames 5 anliegen. An den Öffnungen ist der Frame formschlüssig mit den in Schließstellung befindlichen Formteilen 7a, 7b gehalten.

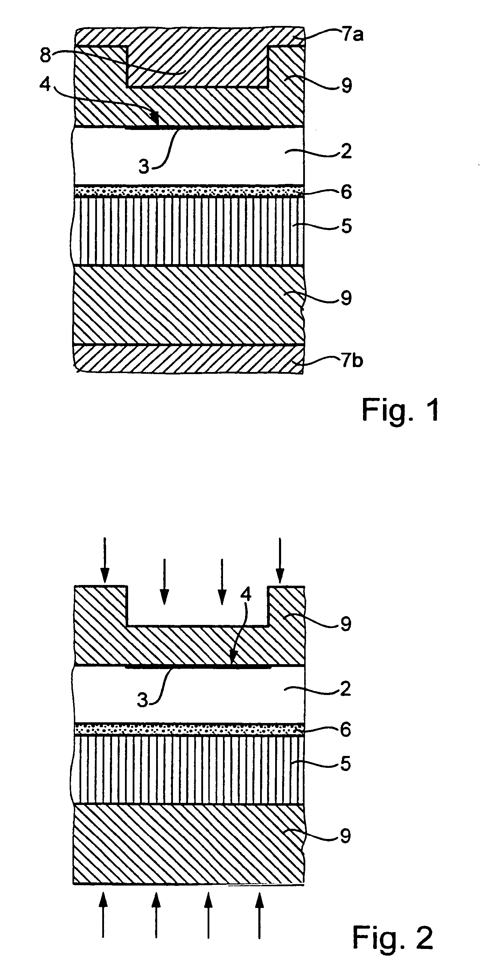

In Fig. 1 ist erkennbar, daß die aus Trägerchip 2, Frame 5 und Klebeschicht 6 gebildete Anordnung an ihren einander abgewandten Flachseiten jeweils von den Innenwandungen der in Schließstellung befindlichen Formteile 7a, 7b beabstandet ist. Wie in Fig.1 weiter erkennbar ist, weist das Formteil 7a des Spritzgießwerkzeugs einen stempelartigen Vorsprung 8 auf, der bei in Schließstellung befindlichem Spritzgießwerkzeug der aktiven Sensorfläche 4 des in die Innenhöhlung des Spritzgießwerkzeuges eingesetzten Trägerchips 2 zugewandt ist. Dabei überdeckt der stempelartige Vorsprung 8 die Sensorfläche 4 der Sensorstruktur 3, wobei der stempelartige Vorsprung 8 mit seinem Umgrenzungsrand mit demjenigen der aktiven Sensorfläche 4 fluchtet. In Fig.1 ist erkennbar, daß der Trägerchip 2 im Bereich der Sensorfläche 4 in einer orthogonal zu Erstreckungsebene des Trägerchips 2 verlaufenden Richtung einen geringeren Abstand zur Innenwand des Formteils 7a aufweist, als in den seitlich an die Sensorfläche 4 angrenzende Bereiche des Trägerchips 2.

Nach dem Schließen des Spritzgießwerkzeugs wird der darin eingesetzte Trägerchip 2 mit einem fließfähigen Material 9, beispielsweise einem Kunststoff, umspritzt. Das fließfähige Material 9 wird über in der Zeichnung nicht dargestellte Zuführkanäle unter Druck und gegebenenfalls Wärmeeinwirkung in die Innenhöhlung des Spritzgießwerkzeuges eingeleitet und füllt die zwischen der aus Trägerchip 2, Frame 5 und Klebeschicht 6 gebildeten Anordnung und den Wandungen der Formteile 7a, 7b befindlichen Freiräume aus. In Fig.1 ist deutlich erkennbar, daß das fließfähige Material auf der aktiven Sensorfläche 4 der Sensorstruktur 3 mit einer geringeren Schichtdicke aufgetragen wird als in dem die aktive Sensorfläche 4 seitlich umgrenzenden Bereich des Trägerchips 2. Nach dem Umspritzen des Trägerchips 2 wird das Material 9 durch Abkühlen verfestigt und erstarrt. Danach werden die umspritzten Trägerchips 2 zusammen mit dem Frame 5 aus dem Spritzgießwerkzeug entnommen.

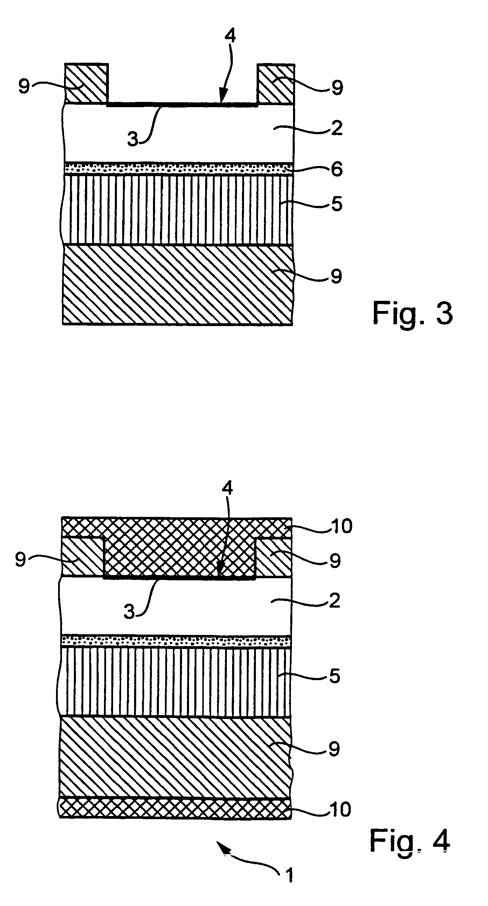

Anschließend wird das Material 9 an seiner dem Trägerchip 2 abgewandten Oberfläche ganzflächig durch Ätzen abgetragen, beispielsweise durch Naßätzen oder durch Plasmaätzen. In Fig.2 ist der Abtragungsprozeß durch Pfeile symbolisch dargestellt. Der Ätzprozeß wird gestoppt, wenn das Material 9 im Bereich der aktiven Sensorfläche 4 vollständig von dem Trägerchip 2 abgetragen und die darunter befindliche Sensorfläche 4 freigelegt ist. Das Ätzmittel wird so gewählt, daß das Material der Sensorstruktur 3 gegen das Ätzmittel chemisch beständig ist und somit die Sensorstruktur 2 durch den Kontakt mit dem Ätzmittel nicht verändert wird. Wie in Fig.3 erkennbar ist, sind die seitlich an die Sensorfläche 4 angrenzenden Bereiche des Trägerchips 2 nach dem Freilegen der Sensorfläche 4 weiterhin von dem Material 9 bedeckt.

Nach dem Freilegen der Sensorfläche 4 wird der Frame 5 mit den daran über die Klebeschicht 6 anhaftenden Trägerchips 2 wieder in das Spritzgießwerkzeug eingesetzt und die Formteile 7a, 7b werden geschlossen. Dabei greifen die vorstehend bereits erwähnten Teilbereiche des Frames 5 in die diesen zugeordneten Öffnungen des Spritzgießwerkzeugs ein, wodurch der Frame 5 in derselben Lage in der Innenhöhlung des Spritzgießwerkzeugs positioniert ist, wie beim Umspritzen mit dem fließfähigen Material 9. An den Stellen, an denen Material 9 an der Umspritzung des Trägerchips 2 weggeätzt wurde, verbleibt zwischen dem mit dem Material 9 umspritzten Trägerchip 2 und der dazu jeweils benachbarten Innenwand der Formteile 7a, 7b ein Freiraum. In diesen Freiraum wird durch die Zuführkanäle der Formteile 7a, 7b hindurch ein fließfähiges Zusatzmaterial 10 eingespritzt, das den Freiraum ausfüllt. Das Zusatzmaterial 10 wird dann verfestigt, beispielsweise durch Erstarren und/oder Aushärten. Bei dem in Fig.4 gezeigten Ausführungsbeispiel ist das Zusatzmaterial 10 optisch transparent und bildet ein für zu detektierende optische Strahlung durchlässiges Fenster. Durch dieses Fenster hindurch kann die zu detektierende Strahlung zu der lichtempfindlichen Sensorfläche 4 der Sensorstruktur 3 gelangen.

Bei dem Verfahren zum Herstellen des Sensors 1 wird also ein Trägerchip 2 bereitgestellt, der eine Sensorstruktur 3 mit einer aktiven Sensorfläche 4 aufweist. Auf Trägerchips 2 wird ein fließfähiges Material 9 derart aufgebracht, daß es auf der aktiven Sensorfläche 4 der Sensorstruktur 3 eine geringere Schichtdicke aufweist als in dem seitlich an die aktive Sensorfläche 4 angrenzenden Bereich des Trägerchips 2. Danach wird das fließfähige Material 9 verfestigt. Anschließend wird das verfestigte Material 9 an seiner dem Trägerchip 2 abgewandten Oberfläche chemisch abgetragen, bis die aktive Sensorfläche der Sensorstruktur freigelegt ist.

## Patentansprüche

1. Verfahren zum Herstellen eines Sensors (1), wobei ein eine Sensorstruktur (3) mit einer aktiven Sensorfläche (4) aufweisender Trägerchip (2) bereitgestellt und auf den die aktive Sensorfläche (4) umgrenzenden Oberflächenbereich des Trägerchips (2) ein fließfähiges Material (9) als Umgrenzung aufgebracht und dieses Material (9) anschließend verfestigt wird, und daß das fließfähige Material (9) auf der aktiven Sensorfläche (4) der Sensorstruktur (3) mit einer geringeren Schichtdicke aufgetragen wird als in dem die aktive Sensorfläche (4) umgrenzenden Bereich des Trägerchips (2), **dadurch gekennzeichnet daß** das fließfähige Material (9) nach seinem Verfestigen an seiner dem Trägerchip (2) abgewandten Oberfläche ganzflächig chemisch abgetragen wird, bis die aktive Sensorfläche (4) der Sensorstruktur (3) freigelegt ist.

2. Verfahren nach Anspruch 1, **dadurch gekennzeichnet, daß** das fließfähige Material (9) nach dem Verfestigen durch Ätzen abgetragen wird, insbesondere durch Plasmaätzen.

3. Verfahren nach Anspruch 1 oder 2, **dadurch gekennzeichnet, daß** das fließfähige Material (9) in einem Spritzgießwerkzeug auf den Trägerchip (2) aufgespritzt wird und daß das Spritzgießwerkzeug einen stempelartigen Vorsprung (8) aufweist, der in Gebrauchstellung der aktiven Sensorfläche (4) zugewandt ist und diese überdeckt und mit seinem Umgrenzungsrand mit demjenigen der aktiven Sensorfläche (4) fluchtet.

4. Verfahren nach einem der Ansprüche 1 bis 3, **dadurch gekennzeichnet, daß** zumindest auf die freigelegte Sensorfläche (4) der Sensorstruktur (3) ein die Sensorfläche (4) überdeckendes, fließfähiges Zusatzmaterial (10) aufgetragen und danach verfestigt wird.

5. Verfahren nach einem der Ansprüche 1 bis 4, **dadurch gekennzeichnet, daß** das fließfähige Zusatzmaterial (10) in dem Spritzgießwerkzeug auf den Sensor (1) aufgespritzt wird.

6. Verfahren nach einem der Ansprüche 1 bis 5, **dadurch gekennzeichnet, daß** der Trägerchip (2) beim Aufbringen des fließfähigen Materials (9) und gegebenenfalls des Zusatzmaterials (10) auf einem Frame (5) angeordnet ist, daß in der Innenhöhlung des Spritzgießwerkzeug Öffnungen für die Aufnahme und/oder den Durchtritt von Teilbereichen des Frames (5) vorgesehen sind, und daß die Umgrenzungsränder der Öffnungen in Gebrauchsstellung dichtend an diesen Teilbereichen anliegen.

7. Verfahren nach einem der Ansprüche 1 bis 6, **dadurch gekennzeichnet, daß** als fließfähiges Material ein photoempfindliches Material (9) auf die aktive Sensorfläche (4) und den diese umgrenzenden Oberflächenbereich des Trägerchips (2) aufgebracht wird, daß das Material (9) danach mittels eines Maskierungs- und Entwicklungsprozesses derart bereichsweise abgetragen wird, daß das verbleibende Material (9) auf der aktiven Sensorfläche (4) der Sensorstruktur (3) eine geringere Schichtdicke aufweist als in dem die aktive Sensorfläche (4) umgrenzenden Bereich des Trägerchips (2), und daß das Material (9) danach ganzflächig chemisch abgetragen wird, bis die aktive Sensorfläche (4) der Sensorstruktur (3) freigelegt ist.

## Claims

1. A method for producing a sensor (1), whereby a carrier chip (2) having a sensor structure (3) with an active sensor surface (4) is provided and a free-flowing material (9) is applied as a boundary onto the surface region of the carrier chip (2) bounding the active sensor surface (4) and this material (9) is then hardened, and the free-flowing material (9) is applied to the active sensor surface (4) of the sensor structure (3) in a thinner layer than in the region of the carrier chip (2) bounding the active sensor surface (4) of the sensor structure (3),
**characterised in that** after the free-flowing material (9) has hardened, it is chemically removed over its entire surface facing away from the carrier chip (2) until the active sensor surface (4) of the sensor structure (3) is exposed.

2. A method according to Claim 1,
**characterised in that** after the free-flowing material (9) has hardened, it is removed by etching, in particular by plasma etching.

3. A method according to Claim 1 or 2,
**characterised in that** the free-flowing material (9) is sprayed in an injection moulding tool onto the carrier chip (2)
**and in that** the injection moulding tool comprises a die-type protrusion (8), which in the position of use faces the active sensor surface (4) and covers it and with its boundary edge aligns with the boundary edge of the active sensor surface (4).

4. A method according to one of Claims 1 to 3,
**characterised in that** a free-flowing additive material (10) that covers the sensor surface (4) is applied at least to the exposed sensor surface (4) of the sensor structure (3) and then is hardened.

5. A method according to one of Claims 1 to 4,
**characterised in that** the free-flowing additive material (10) in the injection moulding tool is sprayed onto the sensor (1).

6. A method according to one of Claims 1 to 5,
**characterised in that** during the application of the free-flowing material (9) and possibly of the additive material (10), the carrier chip (2) is disposed on a frame (5),
**in that** openings for the housing and/or the passage of portions of the frame (5) are provided in the inner cavity of the injection moulding tool,
**and in that** the boundary edges of the openings abut these portions in sealing manner in the position of use.

7. A method according to one of Claims 1 to 6,
**characterised in that** a photosensitive material (9) is applied as a free-flowing material to the active sensor surface (4) and the surface region of the carrier chip (2) that bounds it,
**in that** the material (9) is then removed in some regions by means of a masking and development process in such a manner that the remaining material (9) on the active sensor surface (4) of the sensor structure (3) is a thinner layer than in the region of the carrier chip (2) bounding the active sensor surface (4),
**and in that** the material (9) is then chemically removed over the whole surface until the active sensor surface (4) of the sensor structure (3) is exposed.

## Revendications

1. Procédé de fabrication d'un capteur (1), selon lequel on prépare une puce de support (2) présentant une structure de capteur (3) avec une surface de capteur active (4) et on dépose sur la zone superficielle de la puce de support (2) entourant la surface de capteur active (4) un matériau coulant (9) servant d'entourage et ensuite on solidifie ce matériau (9), le matériau coulant (9) étant déposé sur la surface de capteur active (4) de la structure de capteur (3) avec une épaisseur de couche plus faible que dans la zone de la puce de support (2) entourant la surface de capteur active (4),
**caractérisé en ce qu'**
après sa solidification, on enlève chimiquement le matériau coulant (9) au niveau de toute sa surface détournée de la puce de support (2) jusqu'à ce que la surface de capteur active (4) de la structure de capteur (3) soit dégagée.

2. Procédé selon la revendication 1,
**caractérisé en ce qu'**
après la solidification, on enlève le matériau coulant (9) par gravure, en particulier par gravure à plasma.

3. Procédé selon la revendication 1 ou 2,
**caractérisé en ce qu'**
on injecte le matériau coulant (9) sur la puce de support (2) dans un outil de moulage par injection, et l'outil de moulage par injection présente une saillie (8) en forme de cachet qui dans la position d'utilisation est tournée vers la surface de capteur active (4) et recouvre celle-ci et est alignée par son bord d'entourage avec celui de la surface de capteur active (4).

4. Procédé selon l'une quelconque des revendications 1 à 3,
**caractérisé en ce qu'**
au moins sur la surface de capteur (4) de la structure de capteur (3) dégagée, on dépose et on solidifie un matériau coulant additif (10) recouvrant la surface de capteur (4).

5. Procédé selon l'une quelconque des revendications 1 à 4,
**caractérisé en ce qu'**
on injecte le matériau coulant additif (10) sur le capteur (1) dans l'outil de moulage à injection.

6. Procédé selon l'une quelconque des revendications 1 à 5,
**caractérisé en ce que**
lors du dépôt du matériau coulant (9) et le cas échéant du matériau coulant additif (10), la puce de support (2) est disposée sur un châssis (5), le volume intérieur de l'outil de moulage par injection présente des ouvertures pour le logement et/ou le passage de zones partielles du châssis, et dans la position d'utilisation les bords d'entourage des ouvertures s'appliquent de manière étanche contre ces zones partielles.

7. Procédé selon l'une quelconque des revendications 1 à 6,
**caractérisé en ce que**
comme matériau coulant, on dépose un matériau photosensible (9) sur la surface de capteur active (4) et la zone superficielle de la puce de support (2) entourant celle-ci, le matériau (9) est ensuite enlevé partiellement au moyen d'un processus de masquage et de développement de sorte que le matériau (9) restant sur la surface de capteur active (4) de la structure de capteur (3) présente une épaisseur de couche plus faible que dans la zone de la puce de support (2) entourant la surface de capteur active (4), et toute la surface du matériau (9) est ensuite enlevée chimiquement jusqu'à ce que la surface de capteur active (4) de la structure de capteur soit dégagée.
